# EUROPÄISCHE PATENTANMELDUNG

(11) **EP 1 132 732 A2**
(43) Veröffentlichungstag der Anmeldung: **12.09.2001**
(21) Anmeldenummer: 01105080.4
(22) Anmeldetag: 02.03.2001
(51) Int. Cl.: G01N 21/95, G01N 21/956

(54) **Verfahren zur Bewertung von strukturfehlern auf einer Waferoberfläche**

(30) Priorität: 08.03.2000 DE 10011200
(71) Anmelder: Leica Microsystems Jena GmbH, 07745 Jena (DE)
(72) Erfinder: Wienecke, Joachim, Dr., 07747 Jena (DE)
(74) Vertreter: Reichert, Werner F., Dr.

(57) **Zusammenfassung**

Die Erfindung bezieht sich auf ein Verfahren zur Bewertung von Strukturfehlern auf einer Waferoberfläche, umfassend folgende Schritte: Erfassen der Oberflächeninformationen von einer Vielzahl von Einzelbildfeldern (4) eines in Serie produzierten Wafers 1, Speicherung der Informationen in einem Referenzinformationssatz und Bereitstellung als Referenzinformation für die Inspektion weiterer Wafer derselben Serie; Inspektion der Einzelbildfelder (4) auf der Oberfläche eines aktuell zu untersuchenden Wafers 1 zeitlich nacheinander, dabei Abrufen einer dem jeweils aktuell inspizierten Einzelbildfeld (4) entsprechenden Referenzinformation aus dem Referenzinformationssatz, Vergleichen der Oberfläche jedes aktuell inspizierten Einzelbildfeldes (4) mit der entsprechenden Referenzinformation, bei Feststellung einer oder mehrerer Abweichungen nachfolgende Klassifikation in kritische und unkritische Fehler im Hinblick auf die Funktionsfähigkeit der Chips und zugleich Aktualisierung bzw. Ergänzung des Referenzinformationssatzes.

## Beschreibung

Die Erfindung bezieht sich auf ein Verfahren zur Bewertung von Strukturfehlern auf einer Waferoberfläche.

Für die Chipherstellung vorgesehene strukturierte Wafer lassen sich praktisch nicht ohne Abweichungen von der Idealstruktur herstellen. Die Flächenausdehnung von Abweichungen, welche die Funktionsfähigkeit eines Chips negativ beeinträchtigen können, liegt im Mikrometerbereich. Solche Strukturfehler lassen sich beispielsweise unter einem Mikroskop erkennen.

Abweichungen sind beispielsweise danach klassifizierbar, ob sie einen Chip unbrauchbar machen oder nicht. Es sind Abweichungen denkbar, die aufgrund ihrer Lage und Charakteristik die Unbrauchbarkeit des Chips verursachen, selbst wenn sie nur einzeln auftreten. Andererseits kann selbst eine größere Anzahl von Abweichungen ohne Auswirkungen auf die Funktionsfähigkeit des Chips bleiben.

Zur Erfassung der Abweichungen werden automatisierte Untersuchungsverfahren eingesetzt, die einen in eine Vielzahl von Einzelbildfeldern aufgelösten Chip feldweise überprüfen. Angesichts der hohen Zahl an Einzelbildfeldern, die jeweils eine große Anzahl von Detailbildinformationen aufweisen, kann wegen der hohen Informationsdichte die erzeugte Datenmenge rechentechnisch nicht schnell genug verarbeitet werden. Vielmehr beschränkt man sich bei Online-Prüfungsverfahren zunächst auf die Fragestellung, ob an einem Einzelbildfeld überhaupt eine Abweichung festzustellen ist oder nicht. Der Abgleich erfolgt dabei nicht gegenüber einem Referenzbild, sondern durch Vergleich mit einem unmittelbar zuvor untersuchten Chip oder Wafer. Dies ist deswegen praktikabel, weil die Anzahl zufälliger Abweichungen im Verhältnis zu der Anzahl von zu untersuchenden Bildpunkten sehr gering ist. Systematische Abweichungen lassen sich hierbei allerdings nicht erkennen.

Soll die Entscheidung, ob ein Wafer auszusondern ist, nicht allein in Abhängigkeit von statistisch vorbestimmten Grenzwerten getroffen werden, so ist es erforderlich, die mit einer Abweichung behafteten Einzelbilder in einem weiteren Arbeitsschritt "offline" erneut zu untersuchen, indem der betroffene Wafer der Fertigungslinie entnommen wird. Die abweichungsbehafteten Einzelbildfelder müssen dazu erneut sehr zeitaufwendig betrachtet und von einer Person individuell bewertet werden, wobei diese Person zwar teilweise auf vorformulierte Entscheidungsregeln zurückgreifen kann, vielfach jedoch auf ihre persönliche Untersuchungserfahrung angewiesen ist und ggf. auch intuitiv entscheiden muß.

Eine Vielzahl der untersuchten Abweichungen werden sich dabei als unkritische Pseudofehler herausstellen, während die Gefahr bestehen bleibt, daß eine an sich kritische Abweichung als harmloser Pseudofehler angesehen wird. Die Relevanz der auf diese Art und Weise getroffenen Aussagen für die Entscheidung, ob ein Wafer zur Weiterverarbeitung freigegeben werden kann oder aber ausgesondert werden muß, ist daher nicht befriedigend.

Im Zuge der technischen Fortentwicklung von Computerchips ist eine weitergehende Miniaturisierung der Oberflächenstrukturen zu beobachten, die sich dem mikroskopisch beobachtbaren Bereich zu entziehen beginnt, so daß folglich noch kleinere Abweichungen störungsrelevant werden und bisher angewandte Nachprüfungsmethoden nicht mehr ausreichen.

Die damit ebenfalls erforderliche höhere Auflösung der Einzelbildfelder führt überdies zu einem weiteren Anwachsen der für eine Beurteilung notwendigen Bildinformationen. Hinzu kommt weiterhin eine Tendenz zu der Verwendung von Chips mit insgesamt größerer Oberfläche. Auch dies ist mit einem zusätzlichen Anwachsen der Bildinformationen verbunden und für eine automatische Online-Fehlerkontrolle in einer Waferfertigungslinie mit weitreichender Fehlerbewertung kontraproduktiv.

Bei Verfahren zur Fehlerkontrolle an Wafern sind überdies produktionstechnische Gesichtspunkte mit zu berücksichtigen. So soll eine Fertigungslinie zu Herstellung von Wafern möglichst nicht stillstehen. Würde bei einer kontinuierlichen Untersuchung jeder Pseudofehler einen Aussonderungsvorgang des betreffenden Wafers auslösen, so wäre ein kontinuierlicher Fertigungsprozeß undenkbar, da praktisch jeder Wafer solche Pseudofehler aufweist.

Wollte man mit den bisher bekannten Mitteln "online" eine automatisierte Fehlerbewertung auf der Grundlage der erfaßten Bildinformationen je Einzelbildfeld vornehmen, die über eine Ja/Nein-Aussage im Hinblick auf das Vorhandensein einer Abweichung hinausginge, so wäre der rechentechnische Aufwand immens und würde die heutigen Möglichkeiten weit übersteigen.

So ist in US 5,825,482 ein Oberflächeninspektionssystem beschrieben, bei dem ein Vergleich mit Referenzdaten vorgenommen wird, wobei Fehler auf strukturierten Wafern gefunden werden können. Im Ergebnis der Inspektion stehen sogenannte Waferplots zur Verfügung, die vom Bediener im Hinblick auf Prozeßabweichungen interpretiert werden müssen. Eine automatische Bewertung oder auch Klassifizierung ermittelter Fehler ist nicht möglich und auch nicht vorgesehen.

In der US 5,173,719 ist ein System offenbart, bei dem berücksichtigt wird, daß Schaltkreise Gebiete mit Wiederholstrukturen aufweisen und bei dem zeitgleich sowohl der übliche Chipvergleich als auch die Inspektion der Wiederholstrukturen durchgeführt werden kann. Für den Chipvergleich wird ein Teil der Informationen in einen Verzögerungsspeicher eingelesen und dann mit dem Nachbarchip verglichen. Ähnlich erfolgt die Inspektion von Wiederholstrukturen, wobei der Umfang der zu berücksichtigenden Daten aber wesentlich geringer ist. Es arbeiten zwei Inspektionskanäle gleichzeitig, wobei die Unterscheidung durch Fenstersteuerung erfolgt. Auch hier wird keine Klassifizierung der Fehler vorgenommen.

Die US 5,544,256 beschreibt detailliert ein System, das zur Nachklassifizierung bereits gefundener Fehlerorte ausgebildet ist. Als Grundlage dient ein Labelbild, das aus einem fehlerfreien Referenzbild berechnet wird. Hierzu ist eine überdurchschnittlich hohe Rechenleistung erforderlich, wodurch die Klassifizierung außerordentlich langsam erfolgt und dieses System für einen schnellen Produktionsablauf nicht geeignet ist.

Das vorgenannte Verfahren ist nach US 5,808,735 weiter ausgestaltet. Zur Reduzierung der Falschalarmrate bei der Klassifizierung von Fehlern wird hier ein dreidimensionaler Bild-Bild-Vergleich durchgeführt. Das Referenzbild wird durch ein Array von Bildpunkten beschrieben, wobei jeder Bildpunkt definierte x-y-z-Koordinaten und eine definierte Intensität hat. Die Bildpunkte einer bestimmten Bildebene werden gruppiert und damit ein Schwellwert festgelegt. Eine Klassifizierung mit hohem Tempo wird trotzdem nur bei Beschränkung der Inspektion auf ausgewählte Abschnitte des Wafers erreicht, wodurch auch hier die Voraussetzungen für den Einsatz in einer Prozeßlinie nur ungenügend gegeben sind.

In US 5,699,447 wird eine zweiphasige optische Methode für eine schnelle Inspektion aller kritischen Schichten bei geringer Pseudofehlerrate vorgestellt. Dabei wird in einer ersten Phase der Wafer mit einem Laser schnell abgetastet, während in der zweiten Phase die während der ersten Phase als fehlerverdächtig ermittelten Orte sowie eine Referenzstruktur betrachtet werden. In verschiedenen Fokusebenen werden dann Bilder generiert, um das Vorhandensein eines Fehlers zu bestätigen oder auszuschließen. Diese Verfahrensweise ist ebenfalls verhältnismäßig zeitaufwendig.

Um den Zeitaufwand zu senken, wird in US 5,659,630 ein Inspektionssystem vorgeschlagen, bei dem aus den CAD-Struktur-Daten ein binäres Referenzbild generiert wird. Das laufende Eingangsbild der zu untersuchenden Struktur wird binarisiert, und beide Bilder werden dann einem für jeden Fehlertyp spezifischen Vergleich unterzogen. Der Nachteil liegt einerseits in der immer noch zu langsamen Signalverarbeitung, andererseits in dem großen Hard- und Softwareaufwand, der für jeden einzelnen Fehlertyp zu betreiben ist. Außerdem ist dieses System nur bedingt variabel, da die Hardware für neue Fehlerarten nicht ohne weiteres programmiert werden kann.

In US 5,801,965 sind ein System und ein Verfahren dargestellt, bei dem die Fehlererkennung und Fehlerklassifizierung in eine Prozeßkontrolle integriert werden kann. Das System verwendet allerdings zwei Meßgeräte und weist insofern ebenfalls die bereits genannten Nachteile auf.

Davon ausgehend liegt der Erfindung die Aufgabe zugrunde, ein Verfahren zur Fehlerbewertung an strukturierten Wafern zu schaffen, das mit einer hohen Sicherheit eine Unterscheidung in die Funktionsfähigkeit eines Chips beeinträchtigende (kritische) Fehler und die Funktionsfähigkeit nicht beeinträchtigende (unkritische) Fehler erlaubt.

Diese Aufgabe wird durch ein Verfahren zur Bewertung von Strukturfehlern auf einer Waferoberfläche gelöst, bei dem eine soeben erfaßte Oberflächeninformation eines Einzelbildfeldes der Waferoberfläche mit elektronisch gespeicherten Referenzinformationen verglichen wird, die aus zuvor erfaßten Oberflächeninformationen ortsidentischer Einzelbildfelder aus einer Vielzahl von Waferoberflächen derselben Fertigungsserie und Struktur generiert worden sind.

Im Detail umfasst das Verfahren folgende Schritte: Erfassen der Oberflächeninformation von einer Vielzahl ortsverschiedener Einzelbildfelder der Waferoberfläche, Vergleichen der Oberflächeninformation eines jeden Einzelbildfeldes mit einer Referenzinformation aus einem Referenzinformationssatz, in dem alle zuvor erfaßten Oberflächeninformationen der ortsidentischen Einzelbildfelder von Wafern derselben Struktur gespeichert sind, Feststellen von Abweichungen im Ergebnis des Vergleiches, Klassifizierung in kritische und unkritische Abweichungen und Ausgabe von Hinweisen auf die Einzelbildfelder der Waferoberfläche mit kritischen Abweichungen.

Vorteilhaft ist vorgesehen, daß der Vergleich der Oberflächeninformation eines ersten Einzelbildfeldes mit dem Referenzinformationssatz, die Feststellung von Abweichungen sowie deren Klassifizierung zeitlich parallel zur Erfassung der Oberflächeninformation eines zweiten Einzelbildfeldes erfolgt. Danach wird der Vergleich der Oberflächeninformation des zweiten Einzelbildfeldes mit dem Referenzinformationssatz, die Feststellung von Abweichungen und deren Klassifizierung zeitlich parallel zur Erfassung der Oberflächeninformation eines dritten Einzelbildfeldes vorgenommen und so weiter.

Die erfindungsgemäße Lösung erlaubt eine Waferkontrolle, die online in einer Produktionslinie vorgenommen werden kann. Im Unterschied zu herkömmlichen Verfahren erfolgt hierbei nicht nur eine Ja/Nein-Überprüfung im Hinblick auf das Vorliegen von Abweichungen in den Einzelbildfeldern, sondern vielmehr auch eine Unterscheidung der Fehler. Hierzu wird ausgenutzt, daß nicht in jedem Einzelbildfeld Abweichungen auftreten, so daß die Zeit, in der ein solches abweichungsfreies Einzelbildfeld erfaßt und mit einem Referenzinformationssatz verglichen wird, zur Analyse der Abweichungen in einem früher erfaßten Einzelbildfeld genutzt werden kann.

Durch diese Parallelisierung der Erfassung der Einzelbildfelder und die genauere Untersuchung derjenigen Einzelbildfelder, an denen Abweichungen festgestellt wurden, in Verbindung mit der Nutzung der Informationen aus früher untersuchten Wafern lassen sich die für die Funktionsfähigkeit eines Chips relevanten Abweichungen mit hoher Sicherheit effizient bestimmen. Die Anzahl von Fehlalarmen, die auf einer fälschlichen Bewertung eines Pseudofehlers als kritischen Fehler beruhen, kann drastisch verringert werden.

Die mit dem erfindungsgemäßen Verfahren mögliche Fehlerbeurteilung ist überdies unabhängig davon, ob sich einzelne Strukturen auf dem Wafer oder innerhalb eines Chips oder auch innerhalb eines Einzelbildfeldes wiederholen oder nicht, oder ob diese reguläre oder stochastische Eigenschaften besitzen. Auch lassen sich systematische Fehler, die bisher nicht zu erfassen waren, nunmehr feststellen.

Da das erfindungsgemäße Verfahren ohne eine Offline-Nachinspektion auskommt, ergibt sich eine deutliche Vereinfachung der Bedienungsführung sowie ein erheblicher Zeitgewinn bei der Waferkontrolle bei gleichzeitig verbesserter Relevanz der Aussage hinsichtlich der Weiterverwendbarkeit des Wafers.

In einer vorteilhaften Ausgestaltung der Erfindung werden zur Generierung der Referenzinformationssätze unter Zugrundelegung einer größeren Anzahl von Wafern Oberflächeninformationen für die Einzelbildfelder erfaßt und nach unterschiedlichen Parametern analysiert. Die Referenzinformationssätze für die Informationsbasis werden dauerhaft gespeichert. Auf der Grundlage dieser Informationsbasis läßt sich dann eine schnelle Analyse der während eines Online-Überprüfungsverfahrens untersuchten Wafer vornehmen.

Weiterhin besitzt diese Vorgehensweise den Vorteil, daß die Informationsbasis mit derselben Einrichtung ermittelt werden kann, die später auch zu der Inspektion der Wafer verwendet wird. Bei Umstellung der zu fertigenden Wafer auf eine neue Struktur läßt sich diese Einrichtung somit einfach in einem Lernverfahren an eine neue Waferstruktur anpassen.

Im Unterschied zu einer Nutzung der Entwurfsdaten des Wafers bzw. der einzelnen Chips als Informationsbasis allein lassen sich mit der erfindungsgemäßen Verfahrensweise Fehlinterpretationen, die aus der für die Untersuchung genutzten Einrichtung resultieren, vermeiden. Allerdings ist es durchaus zweckmäßig, die Informationsbasis durch die Entwurfsdaten zu erweitern, da aus diesen beispielsweise Informationen über die Segmentierung des Wafers sowie der einzelnen Chips bekannt sind, die für die Abschätzung der Auswirkung einer Abweichung herangezogen werden können. Im Zuge einer effizienten Datenverwaltung kann es dabei auch vorteilhaft sein, sich an einem Wafer wiederholende Strukturen lediglich nur einmal für alle betreffenden Einzelbildfelder gemeinsam in der Informationsbasis vorzuhalten.

Zur Vermeidung jeglicher Unterbrechungen bei der Online-Inspizierung der Wafer ist es vorteilhaft, wenn bei der Feststellung einer Abweichung die Oberflächeninformationen des betreffenden Einzelbildfeldes in einem Zwischenpuffer abgelegt werden, von wo aus sie dann einer Analysevorrichtung zur genaueren Untersuchung zugeführt werden. Da die genauere Untersuchung der Einzelbildfelder in der Regel mehr Zeit benötigt als die Überprüfung eines Einzelbildfeldes auf das Vorhandensein einer Abweichung, wird durch die Zwischenpufferung vermieden, daß bei in unmittelbar hintereinander inspizierten Einzelfeldern auftretenden Fehlern eine Prozeßunterbrechung der Fließfertigung nötig wird.

Das eine Abweichung enthaltende Einzelbildfeld wird so lange in dem Zwischenpuffer gehalten, bis die zuvor dort ablegten Einzelbildfelder in der Analysevorrichtung überprüft worden sind.

In einer weiteren Ausgestaltung werden in dem Zwischenpuffer gleichzeitig auch die zugehörigen Referenzinformationssätze der Informationsbasis abgelegt und von dort mit den Oberflächeninformationen des Einzelbildfeldes zusammen der Analysevorrichtung zugeführt. Damit ist die genauere Untersuchung von Einzelbildfeldern, die Abweichungen aufweisen, von dem Inspizieren weiterer Einzelbildfelder unabhängig. Die genauere Untersuchung eines Einzelbildfeldes behindert damit nicht die Fortsetzung des Inspizierens weiterer Einzelbildfelder an dem Wafer, die folglich ununterbrochen fortgeführt werden kann.

In einer weiteren vorteilhaften Ausgestaltung der Erfindung werden die Abweichungen in unterschiedliche Fehlertypen klassifiziert und mit der Zuordnung zu dem jeweiligen Fehlertyp visuell dargestellt. Durch die Klassifizierung der Fehler nach ggf. vom Anwender vorgegebenen Kriterien lassen sich durch die hieraus resultierende größere Transparenz Rückschlüsse auf die Ursachen der Fehler ableiten, so daß geeignete Gegenmaßnahmen schneller getroffen werden können.

Vorzugsweise erlauben mehrere Referenzinformationssätze zusammen eine Segmentierung von Einzelbildfeldern in Bereiche mit jeweils gleichartigen Oberflächenstrukturen. Die Klassifizierung der Fehlertypen erfolgt dabei nach der Lage der Abweichungen in den unterschiedlichen Strukturbereichen. Durch diese Segmentierung und die Zuordnung der einzelnen Abweichungen zu den unterschiedlichen Strukturbereichen läßt sich eine Qualifizierung der Abweichungen in kritische und unkritische Fehler mit hoher Güte erzielen. Grund hierfür ist, daß die einzelnen Abweichungen nicht mehr lediglich auf ihren Ort bezogen betrachtet, sondern vielmehr im Kontext ihrer Umgebung abgeschätzt werden. Durch die Einbeziehung dieser Umgebungsinformationen in die Fehlerklassifizierung läßt sich die Nachweisempfindlichkeit maximieren.

Die Segmentierung der Einzelbildfelder kann beispielsweise aus den Entwurfsdaten des Wafers abgeleitet werden. Allerdings ist es auch möglich, die Segmentierung bei der Generierung der Referenzinformationssätze der Informationsbasis zu nutzen, wobei geeignete Algorithmen zur Bildauswertung zur Anwendung gelangen.

In einer weiteren vorteilhaften Ausgestaltung der Erfindung erfolgt die Definition der Fehlertypen anhand der Kombination von Analyseparametern der Oberflächeninformation bekannter Fehler. Die Einteilung der Fehlertypen in unterschiedliche Klassen ist dabei in starkem Maße abhängig von dem Typ des zu untersuchenden Wafers bzw. Chips und folglich diesem in geeigneter Weise anzupassen. Die Definition der Fehlertypen hat dabei vor der eigentlichen Inspizierung der zu untersuchenden Wafer, beispielsweise bei der Generierung der Informationsbasis, zu erfolgen, wobei dies nicht ausschließt, daß bei einem späteren Auftreten neuer Fehler entsprechend neue Fehlertypen definiert und zur Klassifizierung verwendet werden. Vielmehr läßt sich durch eine auch während des Inspektionsbetriebs fortgeführte Belehrung der Analysevorrichtung die Nachweisgenauigkeit für Fehler und die Abgrenzung zu Pseudofehlern weiter verbessern. Diese Informationen werden in den Referenzinformationssätzen abgespeichert.

Zum Inspizieren oder auch zur Auswertung der Einzelbildfelder können unterschiedliche Analyseverfahren eingesetzt werden, mit denen unter anderem unterschiedliche Informationen über die Oberfläche innerhalb eines Einzelbildfeldes gewonnen werden können. Diesen unterschiedlichen Oberflächeninformationen entsprechen jeweils zugeordnete unterschiedliche Typen von Referenzinformationssätzen in der Informationsbasis, mit denen bei einer genaueren Untersuchung eines eine Abweichung enthaltenden Einzelbildfeldes Aussagen über die Charakteristik der Abweichung gewonnen werden können. Die Auswertung der einzelnen Vergleiche ist dabei jedoch verhältnismäßig zeitaufwendig und während eines Online-Prüfungsverfahrens nicht praktikabel. Für die Frage, ob ein Einzelbildfeld näher untersucht werden soll, ist daher die für einen ersten Abgleich erforderliche Informationsmenge zu reduzieren. Vorzugsweise geschieht dies, indem für die Erstuntersuchung aller Einzelbildfelder der gleiche Referenzinformationssatztyp ausgewählt wird, wobei ein solcher bevorzugt wird, der bei allen möglichen in den Einzelbildern auftretenden Oberflächenstrukturen eine hohe Aussagezuverlässigkeit erlaubt.

In einer alternativen Ausführungsform läßt sich die Relevanz der Aussage verbessern, indem in Abhängigkeit von dem zu untersuchenden Einzelbildfeld ein bestimmter Referenzinformationssatztyp ausgewählt wird, wobei die Einzelbildfelder in Klassen kategorisiert sind und jeder Einzelbildfeldklasse ein Referenzinformationssatztyp zugeordnet ist. Dessen Auswahl hat sich daran zu orientieren, daß die für einen Erstvergleich erforderliche Informationsmenge nicht zu einer unverhältnismäßig langen Analysezeit führt, andererseits aber eine ausreichend hohe Relevanz im Hinblick auf das Aussageergebnis aufweist. Da die Klassenzuordnung der Einzelbildfelder bei der Untersuchung gleichartiger Wafer unverändert bleibt, ist es vorteilhaft, wenn diese Information über die jeweiligen Einzelbildfelder in der Informationsbasis ortsabhängig abgelegt wird. Bei der Inspizierung eines Einzelbildfeldes wird für die Feststellung einer Abweichung anhand der in der Informationsbasis abgelegten, dem betreffenden Einzelbildfeld zugeordneten Klasse dann der zugehörige Referenzinformationssatz automatisch ausgewählt.

Alternativ hierzu ist es auch möglich, bei der Inspizierung des Einzelbildfeldes die zugehörige Klasse aus den unmittelbar zur Verfügung stehenden Untersuchungsinformationen zu ermitteln und damit den für die Erstuntersuchung relevanten Referenzinformationssatz auszuwählen.

Vorzugsweise wird in Abhängigkeit von der Klasse des zu erfassenden Einzelbildfeldes ein vorbestimmtes Verfahren zum Inspizieren des Wafers und/oder bestimmte Inspektionsparameter eingestellt, um die Analysegenauigkeit zu verbessern. Hierfür kommen unter anderem die Auflösung sowie der Fokuszustand einer fokussierbaren Inspektionsvorrichtung in Frage.

Die an der Oberfläche des Wafers auftretenden Abweichungen sind oftmals nicht ausschließlich punktueller Natur oder voneinander vollkommen unabhängig. So können beispielsweise Abweichungscluster auftreten, die sich über die Grenzen der Einzelbildfelder oder der einzelnen Chips hinaus erstrecken. Wird bei einer Fehlerbewertung lediglich auf die einzelnen Abweichungen abgestellt, so werden beispielsweise Maskenfehler oder makroskopische Objekte nicht in ihrem Zusammenhang erkannt. In einer vorteilhaften Ausgestaltung der Erfindung erfolgt daher nach der Klassifizierung der Abweichungen nach Fehlertypen eine Untersuchung der fehlerbehafteten Einzelfelder daraufhin, ob diese unmittelbar aneinander angrenzen. Durch diese Information lassen sich vor allem solche Fehler, die zufällig auf einer Grenze zwischen zwei Einzelbildfeldern liegen, besser beurteilen.

Über eine Untersuchung der Fehler nach Fehlertypen hinsichtlich ihrer Lage untereinander an den Wafern können die vorerwähnten Maskenfehler an einem Chip oder auch Kratzer an einem Wafer festgestellt werden.

Die Erfindung wird im Folgenden anhand von Zeichnungen näher erläutert. Die Zeichnungen zeigen in
- Fig.1: eine Darstellung zur Veranschaulichung der Wafersegmentierung, Chipsegmentierung und Einzelbildfeldsegmentierung,
- Fig.2: eine schematische Darstellung der Verfahrensschritte zur Fehlerbeurteilung an einem strukturierten Wafer, wobei eine Unterscheidung nach kritischen Fehlern und unkritischen Fehlern (Pseudofehlern) vorgenommen werden kann,
- Fig.3: ein weiteres Verfahren zur Fehlerbeurteilung, bei dem die auftretenden Fehler nach verschiedenen Typen klassifiziert werden,
- Fig.4: eine schematische Darstellung einer Anordnung zur Durchführung des Verfahrens nach Fig.2,
- Fig.5: eine schematische Darstellung einer Anordnung zur Durchführung des Verfahrens nach Fig.3,
- Fig.6: ein segmentiertes Einzelbildfeld mit einer links dargestellten Idealstruktur, einer in der Mitte dargestellten Realstruktur sowie ein rechts dargestelltes Fehlerbild zur Veranschaulichung einer ersten Art und Weise der Fehlerklassifikation,
- Fig.7: eine weitere Arbeitsweise zur Fehlerklassifikation,
- Fig.8: eine Veranschaulichung der Clusterung von Fehlern.

Die Erfindung wird von folgenden Ausgangsüberlegungen getragen:

Zunächst ist davon auszugehen, daß die Struktur auf einem Wafer vom Entwurf der auf dem Wafer angeordneten Chips her bekannt ist. Dies bedeutet, daß bereits Vergleichs- informationen zur Verfügung stehen, bevor überhaupt mit einer Inspektion der Waferoberfläche begonnen wird. Weiterhin ist die Bedeutung der einzelnen Strukturen der Chips für deren Funktionalität bekannt. Folglich ist es wenig effektiv, erst bei der Erfassung einer Abweichung Überlegungen zu der Umgebung der Abweichung anzustellen, um daraus Schlußfolgerungen für eine Fehlercharakterisierung bzw. -klassifizierung ziehen zu können.

Weiterhin wird zugrunde gelegt, daß in der Regel eine sehr große Anzahl von Wafern mit entsprechend sehr vielen gleichartigen Chips hergestellt werden. Folglich ist es lohnend, sich länger mit der Schaffung einer Vergleichsbasis zu beschäftigen, die sich effizient für eine Abweichungs- bzw. Fehlerermittlung nutzen läßt.

Die erfolgreichste Methode einer Fehlerermittlung ist der Vergleich unter gleichartigen Objekten. Diese Methode erlaubt überdies einen einfachen Wechsel zu einer neuen Struktur. Zur Unterscheidung von Fehlern und Pseudofehlern sowie gegebenenfalls zur Unterscheidung der Fehler in einzelne Fehlertypen wird sowohl das Fehlerbild als auch ein Vergleichsbild benötigt, wobei der Begriff "Bild" hier im Sinne von Bildinformation zu verstehen ist. Während die Bereitstellung des Fehlerbildes keinen großen Aufwand darstellt, ist die Bereitstellung des Vergleichsbildes mit größeren Schwierigkeiten verbunden.

Bei der Inspizierung von Wafern wird die Gesamtinformation über den Wafer und die auf diesem befindlichen Chips in Informationen einer Vielzahl von Einzelbildfeldern zerlegt. Die Anzahl der Einzelbildfelder für eine vollständige Inspektion eines Wafers ist sehr groß und liegt in der Größenordnung von mehreren 100.000. Die Zahl der Abweichungen, die näher betrachtet werden müssen, liegt in der Größenordnung von etwa 1.000. Dies bedeutet aber, daß die Zeit für die Klassifizierung einer Abweichung um das Verhältnis "Anzahl der Einzelbildfelder" zur "Anzahl der zu klassifizierenden Einzelbildfelder" länger als die Inspektionszeit für ein Einzelbildfeld sein kann.

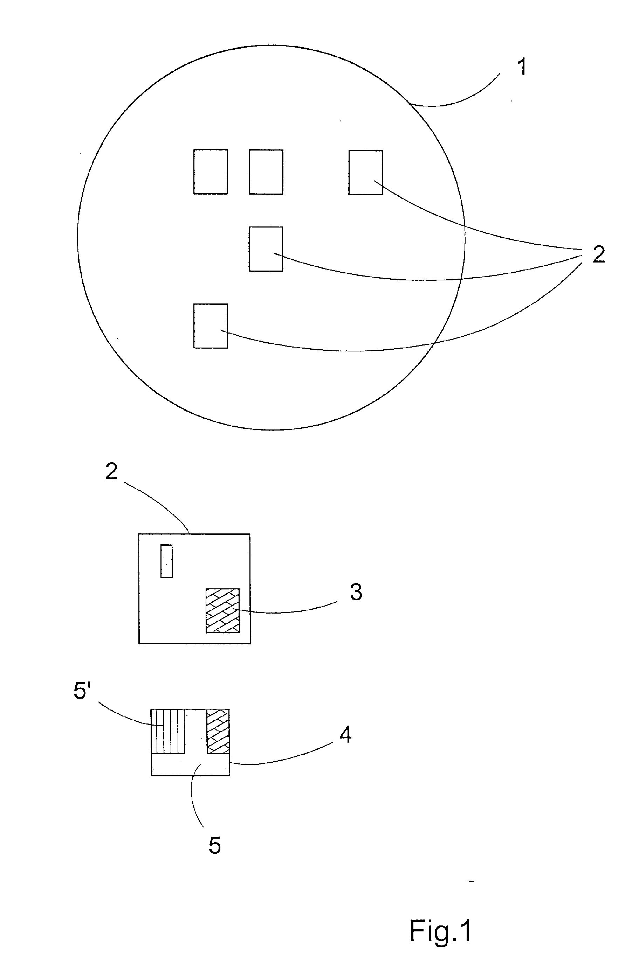

Die Menge der auf einem Wafer vorhandenen und zu bewertenden Oberflächeninformationen ist so groß, daß es notwendig ist, diese zu segmentieren. Eine Vorgehensweise hierzu ist beispielhaft in Fig.1 von oben nach unten dargestellt.

Zur Segmentierung des Wafers 1 gehört zunächst die Information, wieviele Chips 2 sich auf diesem befinden, und an welchen Stellen die Chips 2 in bezug auf ein Absolutkoordinatensystem angeordnet sind.

Auf einer tieferen Hierarchieebene erfolgt dann die Segmentierung des Chips 2 in typische Regionen 3, wobei auf der Basis dieser Einteilung festgelegt bzw. ermittelt werden kann, welche Region 3 mit welchem Inspektionsverfahren und/oder welchen Inspektionsparametern, beispielsweise der Auflösung oder Fokussierung einer Inspektionseinrichtung, inspiziert und klassifiziert wird.

Da sich selbst die Oberflächeninformationen eines Chip 2 nicht auf einmal erfassen lassen, muß dieser in eine Vielzahl von Einzelbildfeldern 4 gegliedert werden. Jedes dieser Einzelbildfelder 4 wird wiederum in Gebiete 5, 5' mit gleichartigen Oberflächenstrukturen aufgeteilt. Durch diese Einzelbildfeldsegmentierung können auftretende Abweichungen im Kontext ihrer Umgebung beurteilt werden, wobei wie oben ausgeführt, bereits aus der Entwurfsphase des Chips bekannt ist, welche Bedeutung den einzelnen Gebieten 5, 5' auf dem Chip 2 zukommt.

Anhand dieser Information kann beispielsweise unterschieden werden, ob ein Fehler in einem für die Funktion des Chips 2 kritischen oder unkritischen Bereich liegt oder beispielsweise auch, ob die Abweichung zwar in einem funktionskritischen Segment liegt, jedoch keine funktionskritische Größe aufweist. Diese Information ist in den Referenzinformationssätzen abgelegt. Durch eine derartige Informationsverknüpfung läßt sich eine hohe Fehler- bzw. Pseudofehlernachweisgenauigkeit erreichen.

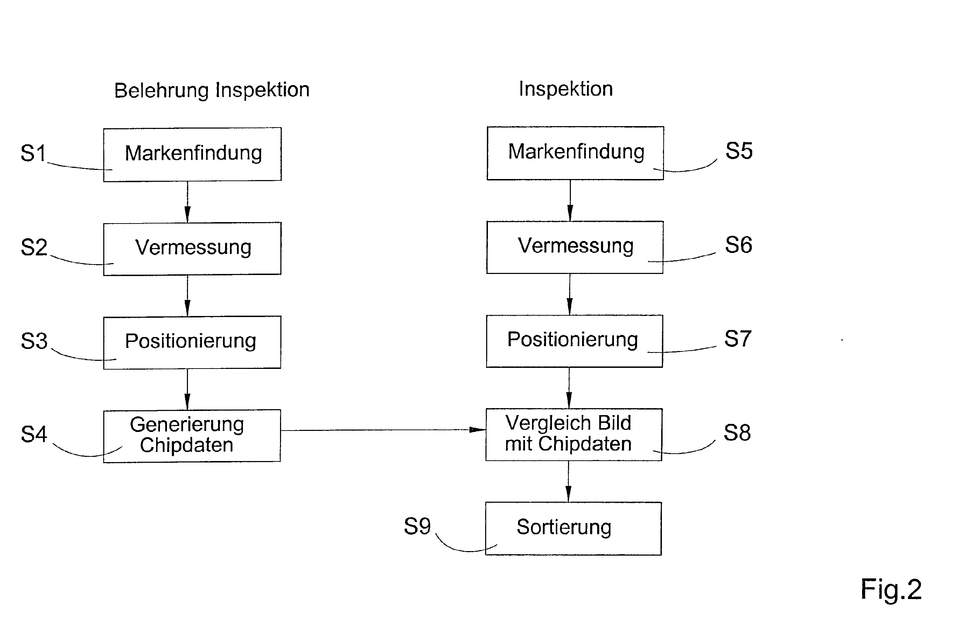

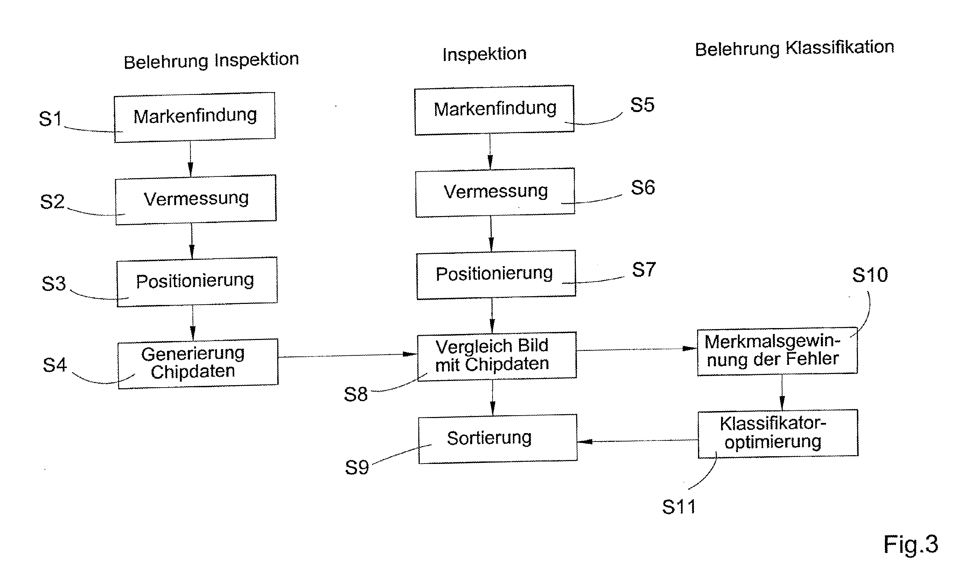

Im folgenden sollen nun zwei Verfahren zur Fehlerbewertung an strukturierten Wafern anhand der Fig.2 und Fig.3 näher erläutert werden, wobei beide Vorgehensweisen auf den erfindungsgemäßen Verfahrensprinzipien beruhen.

Bevor eine Online-Inspektion von Wafern erfolgen kann, ist es zunächst erforderlich, eine Informationsbasis mit Referenzdatensätzen für die später zu untersuchenden Einzelbildfelder des Wafers zu schaffen. Diese Datenbasis deckt gewissermaßen in der Art einer mehrschichtigen "Landkarte" alle interessierenden Gebiete eines Wafers, die nicht notwendigerweise auf die Chip-Abschnitte beschränkt sind, ab. Die einzelnen Schichten der "Landkarte" enthalten dabei nach unterschiedlichen Gesichtspunkten, beispielsweise Analyseparametern, sortierte Informationen über die Oberflächengestalt eines fiktiven Referenzwafers. Jede Schicht kann für ein Einzelbildfeld zu einem Referenzinformationssatz zusammengefaßt und in einem Zentralspeicher abgespeichert werden.

Weiterhin müssen vor einem Inspektionsvorgang Kriterien für die Unterscheidung von Abweichungen in Fehler und Pseudofehler aufgestellt und für die Inspektion bereit gehalten werden.

Erst hiernach kann die Online-Inspektion der zu untersuchenden Wafer erfolgen. Dabei werden die interessierenden Einzelbildfelder in einer optischen Meßeinrichtung hintereinander einzeln angesteuert und optisch untersucht, indem Informationen über die Oberfläche des jeweiligen Einzelbildfeldes erfaßt werden. In einem ersten Untersuchungsschritt werden diese Informationen mit einem geeigneten Referenzinformationssatz abgeglichen, beispielsweise durch einen Bild-zu-Bild-Vergleich auf Pixelbasis, um etwaige Abweichungen festzustellen.

Wird mindestens eine Abweichung festgestellt, so erfolgt eine nähere Untersuchung der erfaßten Oberflächeninformationen in einem weiteren Untersuchungsvorgang, bei dem mehrere oder alle Referenzinformationssätze zu dem betreffenden Einzelbildfeld mit den für dieses erfaßten Oberflächeninformationen verglichen werden. Dieser Vorgang ist jedoch vorteilhafterweise aus der Inspektion und Erstuntersuchung der Einzelbildfelder, die taktweise erfolgt, ausgegliedert und verläuft nur bei Bedarf, d.h. nur bei Feststellung einer Abweichung, zeitlich parallel zu der taktweisen Untersuchung der Einzelbildfelder.

Fig.2 und Fig.3 zeigen jeweils auf der linken Seite die Belehrung einer Vorrichtung zur Fehlerwertung. Die Markenfindung S1, die Vermessung S2 des Wafers und die Positionierung S3 dienen dazu, daß die Bilder gleicher Chips bei der einzelbildfeldweisen Abtastung subpixelgenau zueinander erfaßt werden. Um die Referenzinformationssätze für die Informationsbasis zu generieren (Schritt S4), die gewissermaßen einen fiktiven Referenzwafer darstellt, werden mehrere Wafer bzw. Chips einzelbildfeldweise analysiert. Aus Gründen einer hohen

Genauigkeit läuft dieser Vorgang mit einer geringeren Geschwindigkeit ab, als die spätere Inspektion der zu untersuchenden Wafer.

Aus den Informationen zu den einzelnen Wafern bzw. Chips werden für den Referenz-wafer oder auch für einen Referenzchip gültige Vergleichsinformationen generiert. Diese Vergleichsinformationen werden beispielsweise in Form von Daten in einem Chipspeicher abgelegt. Hierfür kommen primär Mittelwertbilder, die mittleren quadratischen Abweichungen ortabhängig erfaßter Parameter, Multilabelbilder kombiniert mit Materialeigenschaften oder auch CAD- bzw. Maskendaten in Frage.

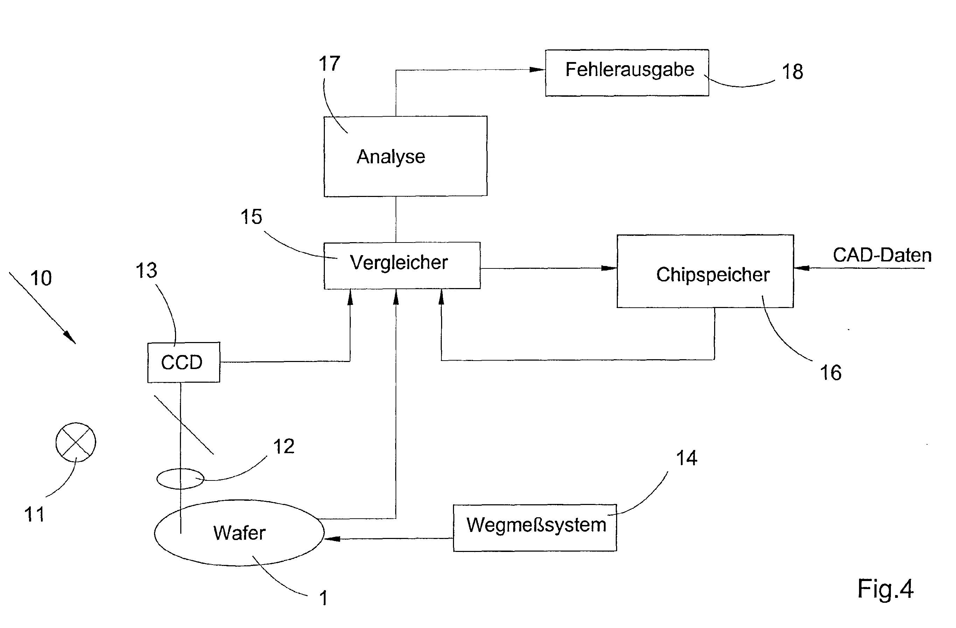

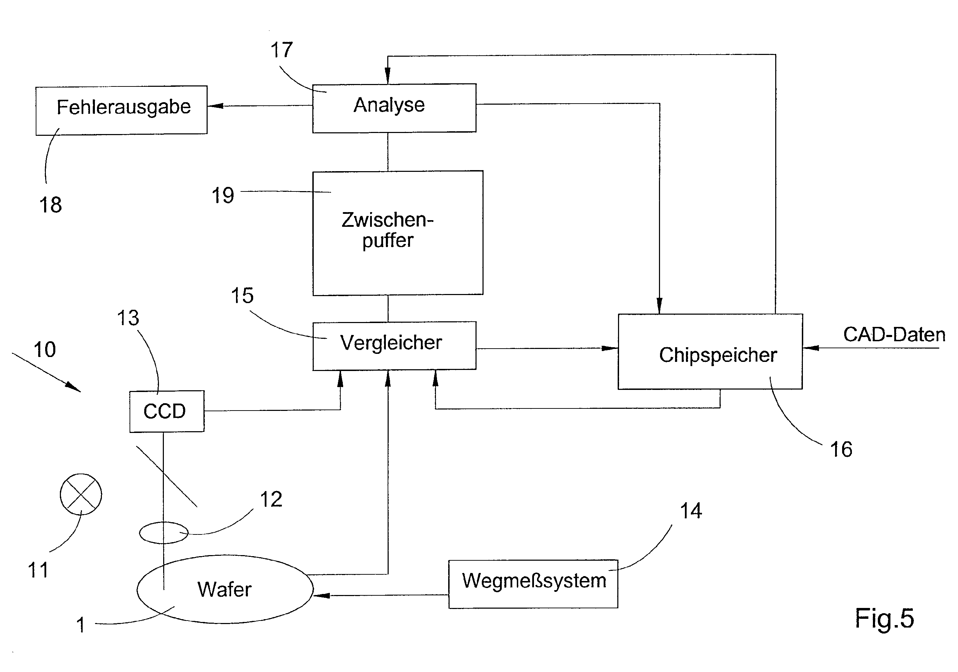

Der eigentliche Inspektionsvorgang erfolgt mit Hilfe einer in Fig.4 und Fig.5 angedeuteten optischen Meßeinrichtung 10. Hierbei wird mittels eines lasergesteuerten Tisches, der den Wafer 1 trägt, das zu inspizierende Einzelbildfeld 4 zu der optischen Meßeinrichtung 10, die beispielsweise eine Beleuchtungsquelle 11, ein Objektiv 12 und einen CCD-Detektor 13 umfaßt, positioniert und abgetastet.

Für eine erfolgreiche Inspektion ist eine möglichst genaue, bevorzugt subpixelgenaue Anbindung der Einzelbildfelder 4 an das Absolutkoordinatensystem des Wafers 1 zu gewährleisten. Die Einzelbildfelder 4 werden hierzu durch den lasergesteuerten Tisch, der mit einem automatischen Wegmeßsystem 14 gekoppelt ist, taktweise hintereinander angefahren und optisch abgetastet. Um Bewegungsunschärfen zu reduzieren und eine Erhöhung der effektiven Belichtungszeit zu ermöglichen, arbeitet der Tisch in einem Start-Stop-Regime.

Wie in Fig.2 angedeutet, erfolgt während der Inspektion für jedes Einzelbildfeld 4 nach einer Markenfindung S5, einer Vermessung S6 und einer Positionierung S7 ein Vergleich S8 der erfaßten Oberflächeninformationen mit einem ausgewählten Referenzinformationssatz, der in einem Schritt S4 "Generierung Chipdaten" generiert wurde und in der Informationsbasis 16 (vgl. Fig.4) gespeichert ist.

Hierzu werden die Oberflächeninformationen des gerade erfaßten Einzelbildfeldes 4 und die Koordinaten des Wegmeßsystems einem Vergleicher 15 (siehe Fig.4) zugeführt. Anhand der damit bekannten Lage des Bildfeldes holt der Vergleicher 15 die für das betreffende Einzelbildfeld 4 relevanten Informationen aus der Informationsbasis 16, nach denen entschieden wird, ob in dem gerade erfaßten Einzelbildfeld 4 eine Abweichung vorliegt oder nicht. Als Ergebnis liegt die Sortierung S9 vor.

Dabei kann der Vergleicher 15 für jedes Einzelbildfeld den gleichen Referenzdatensatztyp verwenden. Da sich die zu untersuchenden Einzelbildfelder 4 je nach Region des Chips 2 in ihrer Struktur stark unterscheiden können, besteht des weiteren auch die Möglichkeit, anhand der an sich bekannten und in der Informationsbasis 16 abgelegten Information einen solchen Referenzdatensatz zur Analyse zu verwenden, der für die betreffende Oberflächenstruktur zur Feststellung einer Abweichung eine besonders hohe Signifikanz besitzt.

Wird eine solche Abweichung festgestellt, so erfolgt eine Weitergabe der erfaßten Oberflächeninformationen des betreffenden Einzelbildfeldes 4 sowie der diesbezüglich vorliegenden Referenzinformationssätze der Informationsbasis in eine Analysevorrichtung 17, in der nach geeigneten Kriterien parallel zu der fortlaufenden weiteren Untersuchung von nachfolgenden Einzelbildfeldern 4 eine genauere Untersuchung anhand vorgegebener Klassifikationskriterien erfolgt, die eine Klassifikation einer Abweichung in Fehler oder Pseudofehler erlaubt (vgl. Sortierung S9 in Fig.2).

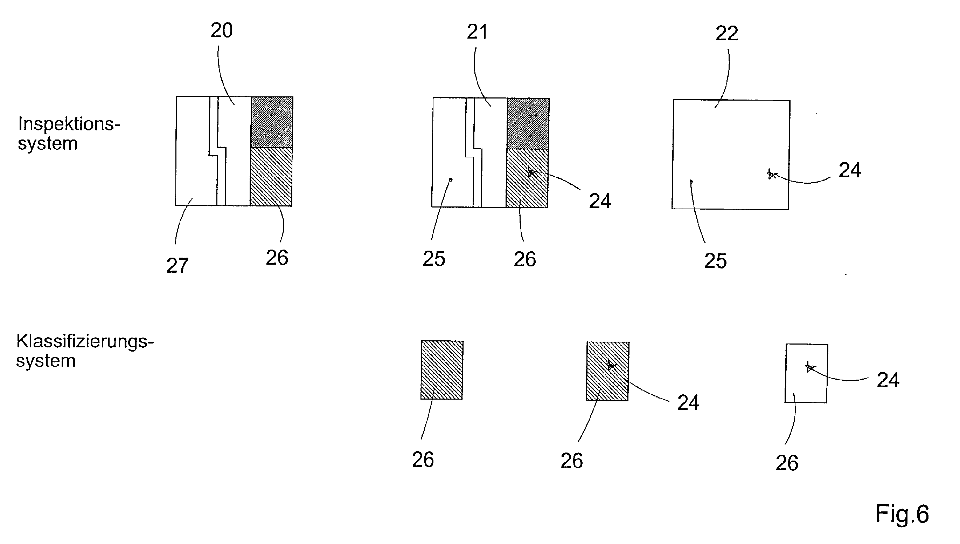

Die Analysevorrichtung 17 ist hierzu vor der Inspektion anhand bekannter Fehler belehrt worden, wobei die Charakterisierung der Fehler sowohl in bezug auf Bildfeldsegmente mit unterschiedlichen Oberflächenstrukturen oder der Kombination von Analyseparametern von Oberflächeninformationen oder auch aus einer Kombination derartiger Informationen erfolgen kann, wie dies beispielsweise in Fig.6 dargestellt ist. Dort ist links das in der Informationsbasis 16 abgelegte Referenz-Einzelbildfeld 20 dargestellt, von dem sich das Real-Einzelbildfeld 21 durch zwei flächenhafte Abweichungen (Fehler 24 und 25) unterscheidet. Aus einem Bildvergleich wird das rechts dargestellte Fehlerbild 22 für das betreffende Einzelbildfeld 4 erhalten, das im vorliegenden Fall Anlaß dazu wäre, das erfaßte Real-Einzelbildfeld 21 anhand weiterer, in der Informationsbasis 16 abgelegter Informationen über das zugehörige Referenz-Einzelbildfeld 20 zu untersuchen.

Im vorliegenden Beispiel erfolgt bei dieser weiteren Untersuchung eine Zuordnung des Fehlers 24 zu einem bestimmten Segment 26 des Referenz-Einzelbildfeldes 20, das hier als für die Funktionsfähigkeit des Chips wesentlicher Bereich betrachtet werden soll. Das helle linke Segment 27 des Referenz-Einzelbildfeldes 20, das in dem Real-Einzelbildfeld 21 ebenfalls eine Abweichung (Fehler 25) aufweist, muß als für die Funktionsfähigkeit des Chips 2 nicht relevanter Bereich hingegen nicht näher untersucht werden. Durch diese Einordnung der Abweichungen in den Kontext ihrer Umgebung läßt sich somit eine Klassifikation der Abweichungen in kritische Fehler 24, die die Funktionsfähigkeit des Chips beeinträchtigen, und unkritische Fehler (25) bzw. sogenannte Pseudofehler, die die Funktionsfähigkeit des Chips nicht beeinträchtigen, vornehmen.

Ein weiteres Ausführungsbeispiel ist in Fig.3, Fig.5 und Fig.7 dargestellt. Dieses Ausführungsbeispiel unterscheidet sich von dem zuvor erläuterten Ausführungsbeispiel vor allem durch die weitergehende Untersuchung kritischer Fehler 24, die in unterschiedliche Fehlertypen unterschieden werden sollen, um den Anwendern weitere Interpretationsmöglichkeiten für die Ursachenforschung zu eröffnen. Wie aus Fig.5 zu erkennen ist, weist die entsprechende Vorrichtung einen dem Vergleicher 15 nachgeschalteten Zwischenpuffer 19 auf, an den bei der Feststellung einer Abweichung in einem Einzelbildfeld 4 die erfaßten Oberflächeninformationen sowie gegebenenfalls auch die zugehörigen Referenzinformationssätze übergeben werden. Der Zwischenpuffer 19 bedient dabei die Eingangsseite einer Analysevorrichtung 17 und verhindert, daß es bei einem Auftreten von Abweichungen in benachbarten oder kurz aufeinander folgenden Einzelbildfeldern 4 zu einer Unterbrechung des Inspektionsvorganges kommt.

In der Analysevorrichtung 17 wird wie in dem vorhergehenden Ausführungsbeispiel nach Fehlern und Pseudofehlern unterschieden, wobei jedoch die Fehler nach Typenklassen sortiert werden. Die Fehler und bei Bedarf auch die Pseudofehler können beispielsweise in einer Liste ausgegeben werden, wobei die Darstellung der Fehler bei dem zweiten Ausführungsbeispiel nach Typenklassen geordnet erfolgen kann. Es ist auch möglich, die festgestellten Fehler über der Waferoberfläche zu visualisieren oder eine andere Darstellungsform zu wählen.

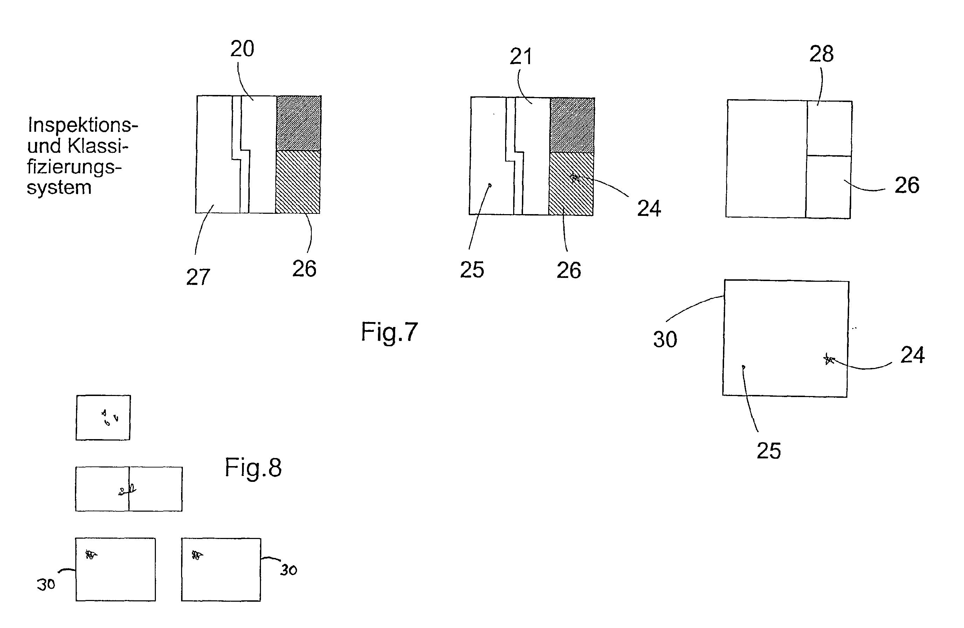

In Fig.7 wird neben einer Strukturbeschreibung 28 des betreffenden Real-Einzelbildfeldes 21 ein entsprechendes Fehlerbild 30 ausgegeben, wobei sowohl die kritischen Fehler 24 als auch die Pseudofehler bzw. unkritischen Fehler 25 dargestellt werden. Durch geeignete Filter kann aber auch eine Darstellung getrennt nach Pseudofehlern und kritischen Fehlern erfolgen, wobei letztere zudem auf einzelne Typenklassen beschränkt werden können.

Zur Verminderung der von dem Zwischenpuffer 19 aufzunehmenden Informationsmenge kann auch lediglich nur das mit einer Abweichung behaftete eben erfaßte Einzelbildfeld 4 bzw. dessen Oberflächeninformationen in dem Zwischenpuffer 19 abgelegt werden. Die für die Fehlerbewertung zusätzlich erforderlichen Referenzinformationssätze werden dann zum Zeitpunkt der Verarbeitung der jeweiligen Einzelbildfelder aus der Informationsbasis 16, d.h. hier dem Zentralspeicher, in die Analysevorrichtung 17 hinzugeladen.

Die Definition der Fehlertypen erfolgt in einem mehrstufigen Prozeß (Schritt S10 "Merkmalsgewinnung" und S11 "Klassifikatoroptimierung" in Fig.3). Hierzu werden beispielsweise bisher nicht bekannte Abweichungen gegenüber dem bereits in der Informationsbasis abgelegten Referenzwafer definiert. Es werden die Merkmale dieser Abweichungen, d.h. beispielsweise bestimmte Analyseparameter, wie Farb- und Helligkeitsinformationen, bestimmt und in geeigneter Weise visualisiert, wobei die Abweichung gleichzeitig im Kontext der umgebenden Oberflächenstruktur betrachtet wird. Der Anwender kann dann interaktiv festlegen, wie die Einteilung der Fehlerklassen erfolgen soll oder nach welchen Fehlern zu suchen ist. Ist die Analysevorrichtung entsprechend belehrt worden, können alle weiteren Wafer mit der gleichen Fragestellung bewertet werden.

Fig.3 zeigt weiterhin, daß auch nach einer erstmaligen Belehrung der Analysevorrichtung 17 anhand des Erkennens weiterer Fehler während der Inspektion von Wafern 1 die Fehlertypenklassifikation angepaßt bzw. bedarfsgerecht erweitert werden kann.

Die bewerteten Fehler werden beispielsweise in einer Liste gespeichert, die wiederum bezogen auf die Grundeinheit des Wafers 1 gefaltet werden kann. Durch die in Fig.6 ansatzweise dargestellte Fehlertypenklassifikation in bezug auf die einzelnen Segmente 26 des Einzelbildfeldes 4, können die für die Funktionsfähigkeit eines Chips 2 kritischen Fehler mit hoher Zuverlässigkeit herausgefunden werden. Überdies können durch die Entkopplung der Bildsegmentierung von der Fehlerfindung und der Fehlerklassifikation über die Informationsbasis für die Strukturklassifikation leistungsfähigere, komplexere Algorithmen zum Einsatz gebracht werden, da die für die Inspektion und die Klassifikation notwendigen Informationen bereits in einer Belehrungsphase bereitgestellt worden sind.

Dem letzteren Ziel dient auch eine Clusterung. Wie beispielhaft in Fig.8 dargestellt, wird nach der Fehlerfindung und Klassifizierung die Information (wie von unten nach oben dargestellt) zusammengefaßt. Dabei geht es darum, bei der Aufteilung in Bildfelder das Zerreißen von Fehlern zu vermeiden, eine richtige Fehlerzuordnung zu gewährleisten und auch eine Doppelzählung von Fehlern zu vermeiden.

### Bezugszeichenliste

- 1: Wafer
- 2: Chip
- 3: Region
- 4: Einzelbildfeld
- 5,5': Gebiete
- 10: Meßeinrichtung
- 11: Beleuchtungsquelle
- 12: Objektiv
- 13: CCD-Detektor
- 14: Wegmeßsystem
- 15: Vergleicher
- 16: Informationsbasis
- 17: Analysevorrichtung
- 19: Zwischenpuffer
- 20: Referenz-Einzelbildfeld
- 21: Real-Einzelbildfeld
- 22: Fehlerbild
- 24: kritische Fehler
- 25: unkritische Fehler
- 26, 27: Segmente
- 28: Strukturbeschreibung
- 30: Fehlerbild
- S1: Markenfindung
- S2: Vermessung des Wafers
- S3: Positionierung
- S4: Generierung Chipdaten
- S5: Markenfindung
- S6: Vermessung
- S7: Postionierung
- S8: Vergleich
- S9: Sortierung
- S10: Merkmalsgewinnung
- S11: Klassifikatoroptimierung

## Patentansprüche

1. Verfahren zur Bewertung von Strukturfehlern auf einer Waferoberfläche, bei dem eine soeben erfaßte Oberflächeninformation eines Einzelbildfeldes (4) der Waferoberfläche mit elektronisch gespeicherten Referenzinformationen verglichen wird, die aus zuvor erfaßten Oberflächeninformationen ortsidentischer Einzelbildfelder (4) aus einer Vielzahl von Waferoberflächen derselben Fertigungsserie und Struktur generiert worden sind.

2. Verfahren nach Anspruch 1, umfassend folgende Verfahrensschritte:
- Erfassen der Oberflächeninformation von einer Vielzahl ortsverschiedener Einzelbildfelder (4) der Waferoberfläche,
- Vergleichen (S8) der Oberflächeninformation eines jeden Einzelbildfeldes (4) mit einer Referenzinformation aus einem Referenzinformationssatz, in dem alle zuvor erfaßten Oberflächeninformationen der ortsidentischen Einzelbildfelder (4) von Wafern derselben Struktur gespeichert sind,
- Feststellen von Abweichungen im Ergebnis des Vergleiches,
- Klassifizierung der Abweichungen in kritische und unkritische Fehler und
- Ausgabe von Hinweisen auf die Einzelbildfelder (4) der Waferoberfläche mit kritischen Fehlern.

3. Verfahren nach Anspruch 2, **dadurch gekennzeichnet, daß** der Vergleich der Oberflächeninformation eines ersten Einzelbildfeldes (4) mit dem Referenzinformationssatz, die Feststellung von Abweichungen und deren Klassifizierung zeitlich parallel zur Erfassung der Oberflächeninformation eines zweiten Einzelbildfeldes (4) erfolgt, danach der Vergleich der Oberflächeninformation des zweiten Einzelbildfeldes (4) mit dem Referenzinformationssatz, die Feststellung von Abweichungen und deren Klassifizierung zeitlich parallel zur Erfassung der Oberflächeninformation eines dritten Einzelbildfeldes (4) erfolgt und so weiter.

4. Verfahren nach Anspruch 2 oder 3, **dadurch gekennzeichnet, daß** zur Gewinnung eines Referenzinformationssatzes die Oberflächeninformationen ortsidentischer Einzelbildfelder (4) von einer Vielzahl von Wafern derselben Struktur erfaßt und nach unterschiedlichen Parametern analysiert werden.

5. Verfahren nach einem der vorgenannten Ansprüche, **dadurch gekennzeichnet, daß** eine Segmentierung eines Einzelbildfeldes (4) in Bereiche mit jeweils gleichartigen Oberflächenstrukturen vorgenommen wird und daß die Klassifizierung der Fehlertypen nach der Lage zu den unterschiedlichen Oberflächenstrukturbereichen erfolgt.

6. Verfahren nach einem der vorgenannten Ansprüche, **dadurch gekennzeichnet daß** die Definition der Fehlertypen anhand der Kombination von Analyseparametern der Oberflächeninformationen bekannter Fehler erfolgt.

7. Verfahren nach einem der vorgenannten Ansprüche, **dadurch gekennzeichnet, daß** für alle Einzelbildfelder (4) zu einem ersten Vergleich (S8) der erfaßten Oberflächeninformationen der gleiche Referenzinformationssatztyp ausgewählt wird.

8. Verfahren nach einem der vorgenannten Ansprüche, **dadurch gekennzeichnet, daß** in Abhängigkeit des zu untersuchenden Einzelbildfeldes (4) für einen ersten Vergleich (S8) ein bestimmter Referenzinformationssatztyp ausgewählt wird, wobei die Einzelbildfelder (4) in Klassen kategorisiert sind und jeder Einzelbildfeldklasse ein Referenzinformationssatztyp zugeordnet ist.

9. Verfahren nach einem der vorgenannten Ansprüche, **dadurch gekennzeichnet, daß** in Abhängigkeit der Klasse des Einzelbildfeldes (4) ein vorbestimmtes Verfahren zum Inspizieren des Wafers (1) und/oder von Inspektionsparametern eingestellt wird.

10. Verfahren nach einem der vorgenannten Ansprüche, **dadurch gekennzeichnet, daß** nach der Klassifizierung der Abweichungen anhand von Fehlertypen alle Fehler bezüglich ihrer Lage an dem Wafer (1) untersucht werden.
